# EUROPEAN PATENT SPECIFICATION

(11) **EP 3 624 182 B1**
(45) Date of publication and mention of the grant of the patent: **20.04.2022**
(21) Application number: 18193912.5
(22) Date of filing: 12.09.2018
(51) Int. Cl.: H01L 23/36, H01L 23/373

(54) **POWER SEMICONDUCTOR MODULE ARRANGEMENT, SUBSTRATE ARRANGEMENT, AND METHOD FOR PRODUCING THE SAME**
LEISTUNGSHALBLEITERMODULANORDNUNG, SUBSTRATANORDNUNG UND VERFAHREN ZUR HERSTELLUNG DAVON
AGENCEMENT DE MODULE SEMICONDUCTEUR DE PUISSANCE, AGENCEMENT DE SUBSTRAT ET SON PROCÉDÉ DE FABRICATION

(43) Date of publication of application: 18.03.2020
(73) Proprietor: Infineon Technologies AG, 85579 Neubiberg (DE)
(72) Inventor: Hohlfeld, Olaf, 59581 Warstein (DE)
(74) Representative: Westphal, Mussgnug & Partner, Patentanwälte mbB

(56) References cited:
- EP-A1- 3 354 707
- DE-A1-102013 215 255
- US-A1- 2008 224 301
- US-A1- 2013 256 868
- US-A1- 2014 246 770

## Description

### TECHNICAL FIELD

The instant disclosure relates to a power semiconductor module arrangement, a substrate arrangement, and a method for producing the same, in particular to a power semiconductor module arrangement comprising a heat sink.

### BACKGROUND

Power semiconductor module arrangements usually include at least one substrate. The substrate may be arranged on a base plate. However, power semiconductor module arrangements without a base plate are also known. A semiconductor arrangement including a plurality of controllable semiconductor components (e.g., two IGBTs in a half-bridge configuration) is usually arranged on at least one of the at least one substrate. Each substrate usually comprises a substrate layer (e.g., a ceramic layer), a first metallization layer deposited on a first side of the substrate layer and a second metallization layer deposited on a second side of the substrate layer. The controllable semiconductor components are mounted, for example, on the first metallization layer. The first metallization layer may be a structured layer while the second metallization layer is usually a continuous layer. The second metallization layer may be attached to a base plate.

Heat that is generated by the controllable semiconductor components is dissipated through the substrate to the base plate and/or to a heat sink. A heat-conducting paste is usually arranged between the substrate and the heat sink or between the base plate and the heat sink to effectively conduct the heat away from the substrate.

Document US 2014/246770 A1 discloses a copper nanorod TIM including a plurality of copper nanorods having a first end thermally coupled with a first surface, and a second end extending toward a second surface. A plurality of copper nanorod branches are formed on the second end. The copper nanorod branches are metallurgically bonded to a second surface. The first surface may be the back side of a die. The second surface may be a heat spread or a second die. The TIM may include a matrix material surrounding the copper nanorods.

Document US 2013/256868 A1 discloses a method for forming a thermal interface material for a semiconductor chip, comprising the steps of forming an initial layer on a substrate, the initial layer including carbon nanotubes and nano metal powder, arranging a semiconductor chip on the initial layer, and heat-treating the initial layer with a sintering temperature of the nano metal powder to obtain a thermal interface material of the carbon nanotubes and the nano metal powder.

Document US 2008/224301 A1 discloses a lead structure for a semiconductor component including external leads for external connections outside a plastic housing composition, internal leads for electrical connections within the plastic housing composition, and a chip mounting island composed of the lead material. While leaving free contact pads of the internal leads, the top sides of the chip mounting island and the internal leads are equipped with nanotubes as an anchoring layer. The plastic housing composition is arranged in the interspaces between the nanotubes arranged on the internal leads, while an adhesive composition for the semiconductor chip is arranged in the interspaces between the nanotubes arranged on the chip mounting island. The adhesive composition and the plastic housing composition fill the interspaces in a manner free of voids.

Document EP 3 354 707 A1 discloses a thermosoftening and heat conductive silicone grease composition including: (A) a silicone wax having a melting point of 30-80°C; (B) an organopolysiloxane having a kinematic viscosity of 10-500,000 mm²/s at 25°C; and (C) a heat conductive filler material having a heat conductivity of at least 10 W/(m^{∗}K).

Document DE 10 2013 215255 A1 discloses an electrical or electronic component with an encapsulating compound, due to which the heat balance of the component is better regulated.

There is a need for an improved power semiconductor module arrangement and improved substrate arrangement which provide for a good thermal conductivity between the substrate or base plate and the heat sink.

### SUMMARY

A power semiconductor module arrangement includes a heat sink, a substrate arrangement arranged on the heat sink in a vertical direction, a heat-conducting paste arranged between a surface of the substrate arrangement and a surface of the heat sink in the vertical direction, wherein a plurality of thermally conducting particles is evenly distributed within the heat-conducting paste, and a plurality of whiskers or fibers. Each of the plurality of whiskers or fibers comprises a first end and a second end, the first end of each of the plurality of whiskers or fibers is inseparably connected to either the surface of the substrate arrangement or to the surface of the heat sink, but not to both, and at least some of the plurality of whiskers or fibers have a length that is significantly less than a distance between the substrate arrangement and the heat sink.

A method for producing a power semiconductor module arrangement includes forming a plurality of whiskers or fibers on at least one of a surface of a heat sink and a surface of a substrate arrangement, applying a heat conducting paste to one of the surface of the substrate arrangement and the surface of the heat sink, thereby enclosing the plurality of whiskers or fibers arranged on the respective surface, wherein a plurality of thermally conducting particles is evenly distributed within the heat-conducting paste, and mounting the substrate arrangement to the heat sink with the heat conducting paste and the plurality of whiskers or fibers arranged between the surface of the substrate arrangement and the surface of the heat sink. Each of the plurality of whiskers or fibers comprises a first end and a second end, the first end of each of the plurality of whiskers or fibers is inseparably connected to either the first surface of the substrate arrangement or to the surface of the heat sink, but not to both, and at least some of the plurality of whiskers or fibers have a length that is significantly less than a distance between the substrate arrangement and the heat sink.

A semiconductor substrate includes a surface, a plurality of whiskers or fibers formed on the surface, and a heat-conducting paste arranged on the first surface of the substrate arrangement and enclosing the plurality of whiskers or fibers. A plurality of thermally conducting particles is evenly distributed within the heat-conducting paste, each of the plurality of whiskers or fibers comprises a first end and a second end, the first end of each of the plurality of whiskers or fibers is inseparably connected to the surface of the substrate arrangement, and at least some of the plurality of whiskers or fibers have a length that is significantly less than a thickness of the heat-conducting paste.

A method for producing a substrate arrangement includes forming a plurality of whiskers or fibers on a surface of the substrate arrangement, applying a heat conducting paste to the surface of the substrate arrangement, thereby enclosing the plurality of whiskers or fibers arranged on the surface, wherein a plurality of thermally conducting particles is evenly distributed within the heat-conducting paste. Each of the plurality of whiskers or fibers comprises a first end and a second end, the first end of each of the plurality of whiskers or fibers is inseparably connected to the first surface of the substrate arrangement, and at least some of the plurality of whiskers or fibers have a length that is significantly less than a thickness of the heat-conducting paste.

The invention may be better understood with reference to the following drawings and the description. The components in the figures are not necessarily to scale, emphasis is instead being placed upon illustrating the principles of the invention. Moreover, in the figures, like reference numerals designate corresponding parts throughout the different views.

### BRIEF DESCRIPTION OF THE DRAWINGS

Figure 1 schematically illustrates a cross-sectional view of a semiconductor substrate arrangement without a base plate.
Figure 2 schematically illustrates a cross-sectional view of a semiconductor substrate arrangement including a base plate.
Figure 3 schematically illustrates a cross-sectional view of a section of the semiconductor substrate arrangement of Figure 2.
Figure 4 schematically illustrates a cross-sectional view of a section of the semiconductor substrate arrangement of Figure 2 according to one example.
Figure 5 schematically illustrates a cross-sectional view of a section of the semiconductor substrate arrangement of Figure 2 according to another example.
Figure 6, including Figures 6A to 6C, schematically illustrates a method for producing a semiconductor substrate arrangement and a power semiconductor module arrangement according to one example.

### DETAILED DESCRIPTION

In the following detailed description, reference is made to the accompanying drawings. The drawings show specific examples in which the invention may be practiced. It is to be understood that the features and principles described with respect to the various examples may be combined with each other, unless specifically noted otherwise. In the description as well as in the claims, designations of certain elements as "first element", "second element", "third element" etc. are not to be understood as enumerative. Instead, such designations serve solely to address different "elements". That is, e.g., the existence of a "third element" does not require the existence of a "first element" and a "second element". A semiconductor body as described herein may be made from (doped) semiconductor material and may be a semiconductor chip or be included in a semiconductor chip. A semiconductor body has electrically connecting pads and includes at least one semiconductor element with electrodes.

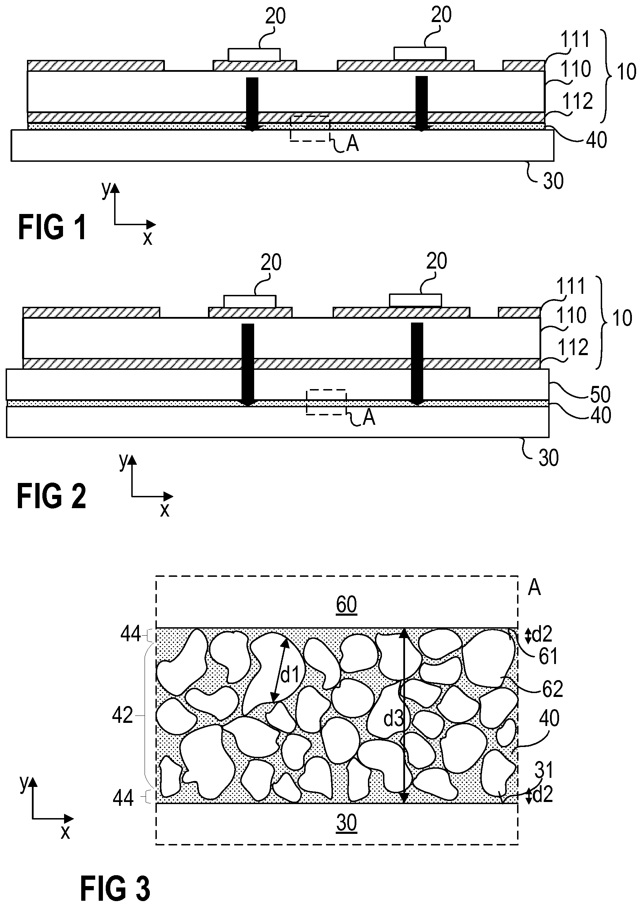

Figure 1 exemplarily illustrates a semiconductor substrate 10. The semiconductor substrate 10 includes a dielectric insulation layer 110, a (structured) first metallization layer 111 attached to the dielectric insulation layer 110, and a second metallization layer 112 attached to the dielectric insulation layer 110. The dielectric insulation layer 110 is disposed between the first and second metallization layers 111, 112.

Each of the first and second metallization layers 111, 112 may consist of or include one of the following materials: copper; a copper alloy; aluminum; an aluminum alloy; any other metal or alloy that remains solid during the operation of the power semiconductor module arrangement. The semiconductor substrate 10 may be a ceramic substrate, that is, a substrate in which the dielectric insulation layer 110 is a ceramic, e.g., a thin ceramic layer. The ceramic may consist of or include one of the following materials: aluminum oxide; aluminum nitride; zirconium oxide; silicon nitride; boron nitride; or any other dielectric ceramic. For example, the dielectric insulation layer 110 may consist of or include one of the following materials: Al₂O₃, AlN, or Si₃N₄. For instance, the substrate may, e.g., be a Direct Copper Bonding (DCB) substrate, a Direct Aluminium Bonding (DAB) substrate, or an Active Metal Brazing (AMB) substrate. A substrate, however, may also be a conventional printed circuit board (PCB) or IMS (Insulated Metall Substrate) having a non-ceramic dielectric insulation layer. For instance, a non-ceramic dielectric insulation layer may consist of or include a cured resin.

Usually one or more semiconductor bodies 20 are arranged on a semiconductor substrate 10. Each of the semiconductor bodies 20 arranged on a semiconductor substrate 10 may include a diode, an IGBT (Insulated-Gate Bipolar Transistor), a MOSFET (Metal-Oxide-Semiconductor Field-Effect Transistor), a JFET (Junction Field-Effect Transistor), a HEMT (High-Electron-Mobility Transistor), or any other suitable controllable semiconductor element. One or more semiconductor bodies 20 may form a semiconductor arrangement on the semiconductor substrate. In Figure 1, two semiconductor bodies 20 are exemplarily illustrated. Any other number of semiconductor bodies 20, however, is also possible.

In the example illustrated in Figure 1, the semiconductor substrate 10 is attached to a heat sink 30 with the second metallization layer 112 arranged between the dielectric insulation layer 110 and the heat sink 30. Heat that is generated by the semiconductor bodies 20 may be dissipated through the semiconductor substrate 10 to the heat sink 30. This is exemplarily illustrated by the bold arrows in Figure 1. The second metallization layer 112 of the semiconductor substrate 10 in Figure 1 is a continuous layer. The first metallization layer 111 is a structured layer in the arrangement illustrated in Figure 1. "Structured layer" in this context means that the first metallization layer 111 is not a continuous layer, but includes recesses between different sections of the layer. Such recesses are schematically illustrated in Figure 1. The first metallization layer 111 in this arrangement exemplarily includes four different sections. Different semiconductor bodies 20 may be mounted to the same or to different sections of the first metallization layer 111. Different sections of the first metallization layer 111 may have no electrical connection or may be electrically connected to one or more other sections using electrical connections such as, e.g., bonding wires. Electrical connections may also include connection plates or conductor rails, for example, to name just a few examples. The first metallization layer 111 being a structured layer, however, is only an example. It is also possible that the first metallization layer 111 is a continuous layer. According to another example, the semiconductor substrate 10 may only comprise a dielectric insulation layer 110 and a first metallization layer 111. The second metallization layer 112 may be omitted.

The power semiconductor module arrangement of Figure 1 does not include a base plate. That is, the semiconductor substrate 10 is directly mounted on a heat sink 30. A layer of heat-conducting paste 40 is arranged between the semiconductor substrate 10 and the heat sink 30. In particular, the layer of heat-conducting paste 40 is arranged between the second metallization layer 112 and the heat sink 30. If the second metallization layer 112 is omitted, the heat-conducting paste 40 may be arranged between the dielectric insulation layer 110 and the heat sink 30.

According to another example, as is schematically illustrated in Figure 2, the power semiconductor module arrangement may additionally include a base plate 50. The base plate 50 may be arranged between the semiconductor substrate 10 and the heat sink 30. The layer of heat-conducting material 40 in this case may be arranged between the base plate 50 and the heat sink 30.

Generally speaking, a power semiconductor module arrangement may comprise a substrate arrangement and a heat sink 30. The substrate arrangement may comprise a semiconductor substrate 10 only (Figure 1), or may comprise a semiconductor substrate 10 arranged on a base plate 50 (Figure 2).

The heat-conducting paste 40 that is applied between the substrate arrangement and the heat sink 30 may comprise a polymer, for example. According to one example, the heat-conducting paste 40 may comprise a silicone oil, or wax. Known heat-conducting pastes 40 generally have a thermal conductivity of between 0.5 and 1W/mK. Other heat-conducting pastes 40 may have a thermal conductivity of up to about 3W/mK, for example. This, however, may not be enough for certain applications. Therefore, in order to further increase the thermal conductivity of the heat-conducting paste 40, thermally conductive particles 62 may be added to the heat-conducting paste 40. This is schematically illustrated in Figure 3, which shows a section A of the power semiconductor module arrangements of Figures 1 and 2. In Figure 3, the heat-conducting paste 40 is arranged between a substrate arrangement 60 and a heat sink 30. The substrate arrangement 60 may be implemented as has been described with respect to Figures 1 and 2 above.

The thermally conductive particles 62 that are added to the heat-conducting paste 40 may be evenly distributed within the heat conducting paste 40. The thermal conductivity of the particles 62 is greater than the thermal conductivity of the heat-conducting paste 40. For example, the particles 62 may have a thermal conductivity of more than 7W/mK. For example, the particles 62 may have a thermal conductivity of between 20 and 200W/mK. The particles 62 may comprise a ceramic material, glass, or a metal powder, for example. The particles 62 may have an average maximum diameter d1 of between 2µm and 10µm, for example. The mixture comprising the heat-conducting paste 40 and the particles 62 has a thermal conductivity that is greater than the thermal conductivity of the heat-conductive paste 40 alone, e.g., a thermal conductivity of between 1W/mK and 5W/mK. The heat dissipation between the substrate arrangement 60 and the heat sink 30, therefore, is increased by adding the particles 62.

The layer of heat-conducting paste 40 between the substrate arrangement 60 and the heat sink 30, however, generally comprises three sections. A first section 42 is a section of comparably high thermal conductivity. This first section 42, however, is arranged between two sections 44 of comparably low thermal conductivity. Generally, the thermal conductivity is lower in the transition zone between the substrate arrangement 60 and the heat conductive paste 40 and in the transition zone between the heat sink 30 and the heat-conductive paste 40. In particular, heat transfer between the surfaces 61, 31 of the substrate arrangement 60 and of the heat sink 30, and the thermally conductive particles 62 is generally comparably poor. The heat transfer may be increased, when the surface roughness of the respective surfaces 61, 31 of the substrate arrangement 60 and the heat sink 30 is reduced, e.g., to less than 20µm. A surface roughness of more than 20µm generally does not increase the heat transfer. On the contrary, if the surface roughness significantly increases, the heat transfer may significantly deteriorate.

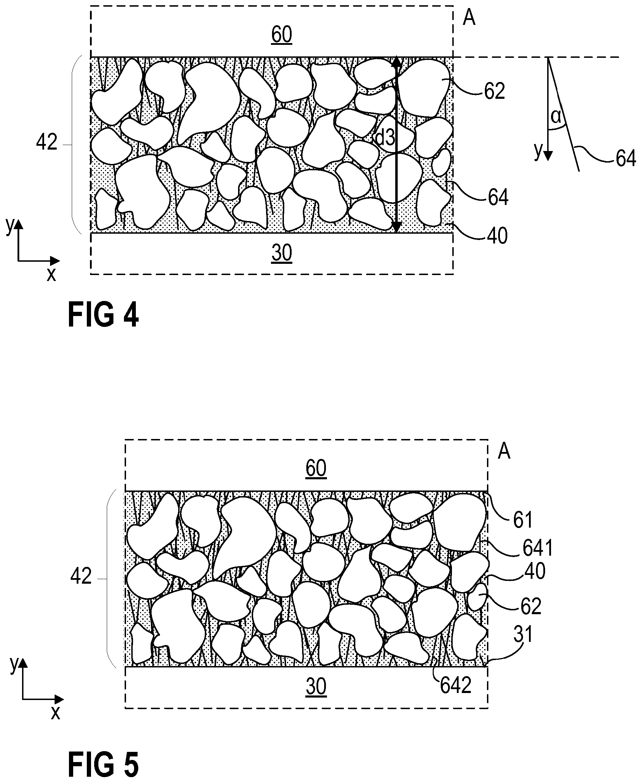

Now referring to Figure 4, in order to increase the thermal path between at least one of the surfaces 31, 61 of the power semiconductor module arrangement and the thermally conductive particles 62, the power semiconductor arrangement further comprises a plurality of whiskers or fibers 64. The surface, e.g., may be the surface 61 of the substrate arrangement 60. As has been described with respect to Figures 1 and 2 above, the surface 61 may be a surface of a semiconductor substrate 10 (surface of second metallization layer 112 or of dielectric insulation layer 110) or a surface of a base plate 50. Each of the plurality of whiskers or fibers 64 has a first end and a second end, and is inseparably connected to the surface 61 with its first end. That is, each of the whiskers or fibers 64 is connected to the surface 61 with a first end and extends from the first surface 61 into the heat-conducting paste 40. The whiskers or fibers 64 may comprise a material having a high thermal conductivity. In particular, the thermal conductivity of the whiskers or fibers 64 may be higher than the thermal conductivity of the heat-conducting paste 40, i.e., in the range of the thermal conductivity of the thermally conductive particles 62. According to one example, the whiskers or fibers 64 may have a thermal conductivity of between 20 and 200W/mK. For example, the whiskers or fibers 64 may comprise a metallic material such as Cu, Al, Cr, Mo, or Wo. According to another example, the whiskers or fibers 64 comprise graphene. Graphene is the basic structural element of many other allotropes of carbon (C), such as graphite or carbon nanotubes, for example.

Whiskers or fibers 64 comprising a metallic material generally are electrically conductive. Therefore, such whiskers or fibers 64 may provide electrically conducting channels between the substrate arrangement 61 and the heat sink 30. For some applications, however, it might be desirable not to provide an electrically conducting connection between the substrate arrangement 61 and the heat sink 30. Therefore, according to another example, the whiskers or fibers 64 may comprise an electrically insulating material such as a ceramic, for example.

Each whisker or fiber 64 may have a maximum length of between 5µm and 50µm. For example, each whisker or fiber 64 may have a length of between 5µm and 20µm. A thickness d2 of the sections of low thermal conductivity 44 (see Figure 3) may be in the range of 1µm, up to several µm. The whiskers or fibers 64 may be long enough to bridge such section of low thermal conductivity 44 (length of whiskers or fibers 64 > d2). In particular, the whiskers or fibers 64 are configured to provide a thermal path between the surface 61 and the thermally conductive particles 62. As the whiskers or fibers 64 extend into the heat-conducting paste 40 in a vertical direction y of the power semiconductor module arrangement, they also contact one or more of the thermally conductive particles 62.

A distance d3 between the substrate arrangement 60 and the heat sink 30 in the vertical direction may be between 20µm and 50µm, for example. A part of the plurality of whiskers or fibers 64 have a length that is significantly less than the distance d3 between the substrate arrangement 60 and the heat sink 30. Such whiskers or fibers 64, therefore, only bridge the short distance d2 of the section of low thermal conductivity 44. Another part of the whiskers or fibers 64, for example, may have a length that lies in the range of the distance d3 between the substrate arrangement 60 and the heat sink 30. Such whiskers or fibers 64 may extend from the surface 61 of the substrate arrangement 60 to the surface 31 of the heat sink 30 and may provide a direct thermal path between the two surfaces 31, 61. The whiskers or fibers 64 may extend parallel to the vertical direction y. This, however, is only an example. As is schematically illustrated in Figure 4, the whiskers or fibers 64 may only essentially extend in the vertical direction such that an angle α of, e.g., 0° < α < 10° results between the whiskers or fibers 64 and the vertical direction y. Different whiskers or fibers 64 may extend differently such that different angles α are formed for different whiskers or fibers 64.

In the example illustrated in Figure 4, the whiskers or fibers 64 are inseparably connected to the first surface 61 of the substrate arrangement 60. This, however, is only an example. It is also possible that, instead, the plurality of whiskers or fibers 64 is inseparably connected to the surface 31 of the heat sink 30 (not illustrated). According to another example that is illustrated in Figure 5, one part of the whiskers or fibers 64 may be inseparably connected to the surface 61 of the substrate arrangement 60 while another part of the whiskers or fibers 64 is inseparably connected to the surface 31 of the heat sink 30. That is, in the example of Figure 5, whiskers or fibers 64 extend into the heat-conductive paste 40 from both surfaces 31, 61 such that the heat transfer between each of the two surfaces 31, 61 and the thermally conductive particles 62 is increased. This results in a single section 42 having a satisfactory heat conduction. Both sections of lower thermal conductivity 44 may be bridged by the whiskers or fibers 64.

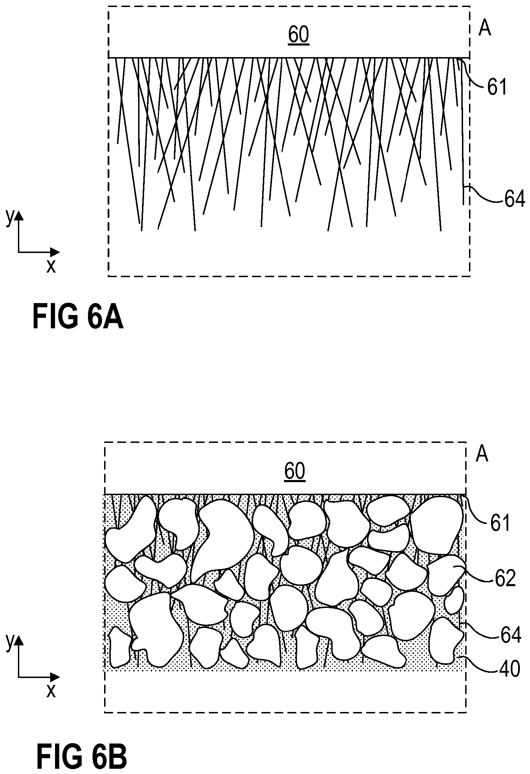

Now referring to Figures 6A - 6C, a method for producing a substrate arrangement 60 and a power semiconductor module arrangement is exemplarily illustrated. A method for producing a substrate arrangement 60 comprises forming a plurality of whiskers or fibers 64 on a surface 61 of the substrate arrangement 60, as is illustrated in Figure 6A. The substrate arrangement 60 may comprise a semiconductor substrate 10 comprising a dielectric insulation layer 110, a first metallization layer 111, and (optionally) a second metallization layer 112, the surface 61 being a surface of the semiconductor substrate 10. According to another example, the substrate arrangement 60 may further comprise a base plate 50, wherein the semiconductor substrate 10 is arranged on the base plate 50, and the surface 61 is a surface of the base plate 50. Forming the plurality of whiskers or fibers 64 may comprise a galvanic growth process. For example, the material that forms the whiskers or fibers 64 may be deposited by galvanic separation. A mask may be arranged on the surface 61 of the substrate arrangement 60, the mask including microstructures such as a plurality of holes. The material may then be deposited in the microstructure, e.g., the holes. After forming the whiskers or fibers 64, the mask may be removed. Each of the whiskers or fibers 64 is inseparably connected to the surface 61 with a first end, while the second end of the whiskers or fibers 64 is a free end.

For example, a plurality of metallic whiskers or fibers 64 may be formed. For example, the whiskers or fibers 64 may comprise aluminum. After forming the metallic whiskers or fibers 64, e.g., with a galvanic growth process, the whiskers or fibers 64 may be exposed to steam. In this way, a metal oxide may be formed. If the whiskers or fibers 64 comprise aluminum, a compound may be formed by aluminum and oxygen, resulting in Al₂O₃. Other metals may be used instead of aluminum that may be transformed to a ceramic by exposing it to steam. According to another example, a nitriding process may be used, wherein nitrogen is diffused into a metal. For example, the metal whiskers or fibers 64 may be exposed to a nitrogen rich gas, e.g., NH₃, thereby forming a nitride.

The substrate arrangement 60 is often produced by a first supplier. The substrate arrangement is then sold and shipped before mounting the substrate arrangement 60 to a heat sink 30. If the same manufacturer produces the substrate arrangement 60 and mounts it to the heat sink 30, it is, however, also necessary to transport the arrangement between different manufacturing plants or production machines. The whiskers or fibers 64 are very fragile and may be easily damaged. In order to protect the micro whiskers or fibers 64 during shipping and/or handling, a heat-conducting paste 40 is applied to the substrate arrangement 60 as is illustrated in Figure 6B. The heat-conducting paste 40 may comprise thermally conductive particles 62. The plurality of whiskers or fibers 64 are completely embedded in the heat-conducting paste 40. That is, the free ends of the whiskers or fibers 64 do not protrude from the heat-conducting paste 40.

A manufacturer of power semiconductor module arrangements may purchase the substrate arrangement 60 with the plurality of whiskers or fibers 64 and the heat-conducting paste 40 arranged thereon. The heat-conducting paste 40, for example, may be a heat-conducting paste that changes its phase depending on temperature. For example, at room temperature, the heat-conducting paste 40 may be solid, semi-solid, viscous or gel-like and may adhere to the surface 61. When heated, the heat-conducting paste 40 may liquefy. For example, the heat-conducting paste 40 may be applied to the substrate arrangement 60 while it is still liquid. The heat-conductive paste 40 may comprise solvents, for example. In a following step the solvents may be removed. The heat-conducting paste 40 may then form a protective layer for the whiskers or fibers 64. For example, the heat-conducting paste 40 may have a low viscosity.

If the whiskers or fibers 64 are formed on the surface 31 of the heat sink 30 instead of on the surface 61 of the substrate arrangement 60 (not illustrated), the heat-conductive paste 40 may be applied to the heat sink 30 instead of to the substrate arrangement 60. If whiskers or fibers 64 are formed on both the surface 61 of the substrate arrangement 60 and the surface 31 of the heat sink, the heat-conductive paste 40 may be applied to one of the surfaces 31, 61 only.

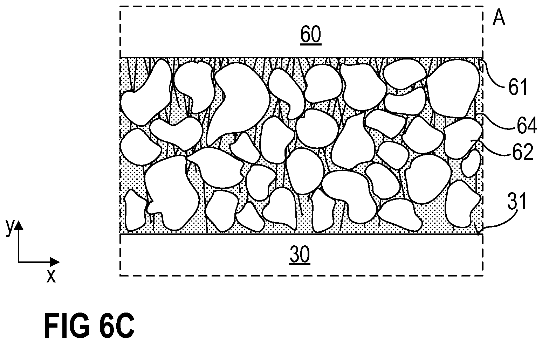

A method for producing a power semiconductor module may further comprise mounting the substrate arrangement 60 comprising a plurality of whiskers or fibers 64 that are embedded in a layer of heat-conductive paste 40 to a heat sink 30. This is schematically illustrated in Figure 6C.

According to another example (not illustrated), the method for forming a power semiconductor module arrangement may alternatively comprise forming a plurality of whiskers or fibers 64 on a surface 31 of the heat sink 30, before mounting the substrate arrangement 60 to the heat sink 30.

## Claims

1. A power semiconductor module arrangement comprising:
a heat sink (30);
a substrate arrangement (60) arranged on the heat sink (30) in a vertical direction;
a heat-conducting paste (40) arranged between a surface (61) of the substrate arrangement (60) and a surface (31) of the heat sink (30) in the vertical direction, wherein a plurality of thermally conducting particles is evenly distributed within the heat-conducting paste (40); and
a plurality of whiskers or fibers (64), wherein each of the plurality of whiskers or fibers (64) comprises a first end and a second end;
**characterized in that**
the first end of each of the plurality of whiskers or fibers (64) is inseparably connected to either the surface (61) of the substrate arrangement (60) or to the surface (31) of the heat sink (30), but not to both; and
at least some of the plurality of whiskers or fibers (64) have a length that is significantly less than a distance (d3) between the substrate arrangement (60) and the heat sink (30).

2. The power semiconductor module arrangement of claim 1, wherein each of the plurality of whiskers or fibers (64) extends essentially in the vertical direction through the heat-conducting paste (40).

3. The power semiconductor module arrangement of claim 1 or 2, wherein
each of the plurality of whiskers or fibers (64) has a length of between 5µm and 50µm, or between 5µm and 20µm.

4. The power semiconductor module arrangement of any of claims 1 to 3, wherein a distance (d3) between the substrate arrangement (60) and the heat sink (30) is between 20µm and 50µm.

5. The power semiconductor module arrangement of any of claims 1 to 4, wherein the whiskers or fibers (64) comprise one of a metallic material, a ceramic material, and graphene.

6. The power semiconductor module arrangement of claim 5, wherein the whiskers or fibers (64) comprise at least one of an oxide, a nitride, Cu, Al, Cr, Mo, Wo, and C.

7. The power semiconductor module arrangement of any of the preceding claims, wherein the semiconductor arrangement (60) comprises a semiconductor substrate (10), and wherein the first surface (61) is a surface of the semiconductor substrate (10).

8. The power semiconductor module arrangement of any of claims 1 to 6, wherein the substrate arrangement (60) comprises a semiconductor substrate (10) mounted to a base plate (50), and wherein the first surface (61) is a surface of the base plate (50).

9. The power semiconductor module arrangement of any of the preceding claims, wherein at least a first part of the plurality of whiskers or fibers (64) extends over the complete distance (d3) between the substrate arrangement (60) and the heat sink (30) such that at least the whiskers or fibers (64) of the first part thermally contact both the substrate arrangement (60) and the heat sink (30).

10. The power semiconductor module arrangement of any of the preceding claims, wherein a thermal conductivity of the plurality of whiskers or fibers (64) is greater than a thermal conductivity of the heat conductive paste (40).

11. Method for producing a power semiconductor module arrangement, the method comprising:
forming a plurality of whiskers or fibers (64) on at least one of a surface (31) of a heat sink (30) and a surface (61) of a substrate arrangement (60);
applying a heat conducting paste (40) to one of the surface (61) of the substrate arrangement (60) and the surface (31) of the heat sink (30), thereby enclosing the plurality of whiskers or fibers (64) arranged on the respective surface (31, 61), wherein a plurality of thermally conducting particles (62) is evenly distributed within the heat-conducting paste (40);
mounting the substrate arrangement (60) to the heat sink (30) with the heat conducting paste (40) and the plurality of whiskers or fibers (64) arranged between the surface (61) of the substrate arrangement (60) and the surface (31) of the heat sink (30);
wherein
each of the plurality of whiskers or fibers (64) comprises a first end and a second end;
the first end of each of the plurality of whiskers or fibers (64) is inseparably connected to either the first surface (61) of the substrate arrangement (60) or to the surface (31) of the heat sink (30), but not to both; and
at least some of the plurality of whiskers or fibers (64) have a length that is significantly less than a distance (d3) between the substrate arrangement (60) and the heat sink (30).

12. The method of claim 11, wherein at least one of
forming the whiskers or fibers (64) comprises a galvanic growth process; and
the heat conducting paste (40) is configured to change its phase depending on temperature, and the step of applying the heat conducting paste (40) comprises heating and liquefying the heat conducting paste (40).

13. Substrate arrangement (60) comprising
a surface (61);
a plurality of whiskers or fibers (64) formed on the surface (61); and
a heat-conducting paste (40) arranged on the first surface (61) of the substrate arrangement (60) and enclosing the plurality of whiskers or fibers (64), wherein a plurality of thermally conducting particles (62) is evenly distributed within the heat-conducting paste (40);
each of the plurality of whiskers or fibers (64) comprises a first end and a second end; the first end of each of the plurality of whiskers or fibers (64) is inseparably connected to the surface (61) of the substrate arrangement (60); **characterized in that**
at least some of the plurality of whiskers or fibers (64) have a length that is significantly less than a thickness (d3) of the heat-conducting paste (40).

14. Method for producing a substrate arrangement (60), the method comprising
forming a plurality of whiskers or fibers (64) on a surface (61) of the substrate arrangement (60);
applying a heat conducting paste (40) to the surface (61) of the substrate arrangement (60), thereby enclosing the plurality of whiskers or fibers (64) arranged on the surface (61), wherein a plurality of thermally conducting particles (62) is evenly distributed within the heat-conducting paste (40); wherein
each of the plurality of whiskers or fibers (64) comprises a first end and a second end; the first end of each of the plurality of whiskers or fibers (64) is inseparably connected to the first surface (61) of the substrate arrangement (60) and
at least some of the plurality of whiskers or fibers (64) have a length that is significantly less than a thickness (d3) of the heat-conducting paste (40).

15. The method of claim 14, wherein at least one of
forming the whiskers or fibers (64) comprises a galvanic growth process; and
the heat conducting paste (40) is configured to change its phase depending on temperature, and the step of applying the heat conducting paste (40) comprises heating and liquefying the heat conducting paste (40).

## Patentansprüche

1. Leistungshalbleitermodulanordnung, umfassend:
eine Wärmesenke (30);
eine Substratanordnung (60), die auf der Wärmesenke (30) in einer vertikalen Richtung angeordnet ist;
eine Wärmeleitpaste (40), die zwischen einer Oberfläche (61) der Substratanordnung (60) und einer Oberfläche (31) der Wärmesenke (30) in der vertikalen Richtung angeordnet ist, wobei eine Vielzahl von wärmeleitenden Partikeln gleichmäßig innerhalb der Wärmeleitpaste (40) verteilt ist; und
eine Vielzahl von Whiskern oder Fasern (64), wobei jede von der Vielzahl von Whiskern oder Fasern (64) ein erstes Ende und ein zweites Ende umfasst;
**dadurch gekennzeichnet, dass**
das erste Ende von jeder von der Vielzahl der Whisker oder Fasern (64) untrennbar mit entweder der Oberfläche (61) der Substratanordnung (60) oder der Oberfläche (31) der Wärmesenke (30) verbunden ist, jedoch nicht mit beiden; und
mindestens einige von der Vielzahl der Whisker oder Fasern (64) eine Länge haben, die signifikant geringer als ein Abstand (d3) zwischen der Substratanordnung (60) und der Wärmesenke (30) ist.

2. Leistungshalbleitermodulanordnung nach Anspruch 1, wobei jede von der Vielzahl der Whisker oder Fasern (64) sich im Wesentlichen in der vertikalen Richtung durch die Wärmeleitpaste (40) hindurch erstreckt.

3. Leistungshalbleitermodulanordnung nach Anspruch 1 oder 2, wobei jede von der Vielzahl der Whisker oder Fasern (64) eine Länge zwischen 5 µm und 50 µm oder zwischen 5 µm und 20 µm hat.

4. Leistungshalbleitermodulanordnung nach einem der Ansprüche 1 bis 3, wobei ein Abstand (d3) zwischen der Substratanordnung (60) und der Wärmesenke (30) zwischen 20 µm und 50 µm liegt.

5. Leistungshalbleitermodulanordnung nach einem der Ansprüche 1 bis 4, wobei die Whisker oder Fasern (64) eines von einem Metallmaterial, einem Keramikmaterial und Graphen umfassen.

6. Leistungshalbleitermodulanordnung nach Anspruch 5, wobei die Whisker oder Fasern (64) mindestens eines von einem Oxid, einem Nitrid, Cu, Al, Cr, Mo, Wo und C umfassen.

7. Leistungshalbleitermodulanordnung nach einem der vorhergehenden Ansprüche, wobei die Halbleiteranordnung (60) ein Halbleitersubstrat (10) umfasst, und wobei die erste Oberfläche (61) eine Oberfläche des Halbleitersubstrats (10) ist.

8. Leistungshalbleitermodulanordnung nach einem der Ansprüche 1 bis 6, wobei die Substratanordnung (60) ein Halbleitersubstrat (10) umfasst, das an einer Basisplatte (50) montiert ist, und wobei die erste Oberfläche (61) eine Oberfläche der Basisplatte (50) ist.

9. Leistungshalbleitermodulanordnung nach einem der vorhergehenden Ansprüche, wobei mindestens ein erster Teil der Vielzahl von Whiskern oder Fasern (64) sich über den vollständigen Abstand (d3) zwischen der Substratanordnung (60) und der Wärmesenke (30) erstreckt, so dass mindestens die Whisker oder Fasern (64) des ersten Teils thermisch in Kontakt mit sowohl der Substratanordnung (60) als auch der Wärmesenke (30) stehen.

10. Leistungshalbleitermodulanordnung nach einem der vorhergehenden Ansprüche, wobei eine Wärmeleitfähigkeit der Vielzahl von Whiskern oder Fasern (64) größer als eine Wärmeleitfähigkeit der Wärmeleitpaste (40) ist.

11. Verfahren zum Fertigen einer Leistungshalbleitermodulanordnung, wobei das Verfahren umfasst:
Bilden einer Vielzahl von Whiskern oder Fasern (64) auf mindestens einer von der Oberfläche (31) der Wärmesenke (30) und einer Oberfläche (61) einer Substratanordnung (60);
Aufbringen einer Wärmeleitpaste (40) auf eine von der Oberfläche (61) der Substratanordnung (60) und der Oberfläche (31) der Wärmesenke (30), wodurch die Vielzahl der Whisker oder Fasern (64) umschlossen wird, die auf der jeweiligen Oberfläche (31, 61) angeordnet sind, wobei eine Vielzahl von wärmeleitenden Partikeln (62) gleichmäßig innerhalb der Wärmeleitpaste (40) verteilt ist;
Montieren der Substratanordnung (60) an die Wärmesenke (30) mit der Wärmeleitpaste (40) und wobei die Vielzahl von Whiskern oder Fasern (64) zwischen der Oberfläche (61) der Substratanordnung (60) und der Oberfläche (31) der Wärmesenke (30) angeordnet ist; wobei
jede von der Vielzahl von Whiskern oder Fasern (64) ein erstes Ende und ein zweites Ende umfasst;
das erste Ende von jeder von der Vielzahl der Whisker oder Fasern (64) untrennbar mit entweder der ersten Oberfläche (61) der Substratanordnung (60) oder der Oberfläche (31) der Wärmesenke (30) verbunden ist, jedoch nicht mit beiden; und
mindestens einige von der Vielzahl der Whisker oder Fasern (64) eine Länge haben, die signifikant geringer als ein Abstand (d3) zwischen der Substratanordnung (60) und der Wärmesenke (30) ist.

12. Verfahren nach Anspruch 11, wobei mindestens eines der folgenden zutrifft:
das Bilden der Whisker oder Fasern (64) umfasst einen galvanischen Wachstumsprozess; und
die Wärmeleitpaste (40) ist dazu ausgebildet, ihre Phase in Abhängigkeit von der Temperatur zu ändern, und der Schritt des Aufbringens der Wärmeleitpaste (40) umfasst das Erwärmen und Verflüssigen der Wärmeleitpaste (40).

13. Substratanordnung (60), umfassend:
eine Oberfläche (61);
eine Vielzahl von Whiskern oder Fasern (64), die auf der Oberfläche (61) gebildet sind; und
eine Wärmeleitpaste (40), die auf der ersten Oberfläche (61) der Substratanordnung (60) angeordnet ist und die Vielzahl von Whiskern oder Fasern (64) umschließt, wobei die Vielzahl der wärmeleitenden Partikel (62) innerhalb der Wärmeleitpaste (40) gleichmäßig verteilt ist;
wobei jede von der Vielzahl der Whisker oder Fasern (64) ein erstes Ende und ein zweites Ende umfasst;
wobei das erste Ende von jeder von der Vielzahl der Whisker oder Fasern (64) untrennbar mit der Oberfläche (61) der Substratanordnung (60) verbunden ist; **dadurch gekennzeichnet, dass** mindestens einige von der Vielzahl der Whisker oder Fasern (64) eine Länge haben, die signifikant geringer als eine Dicke (d3) der Wärmeleitpaste (40) ist.

14. Verfahren zur Herstellung einer Substratanordnung (60), wobei das Verfahren umfasst:
Bilden einer Vielzahl von Whiskern oder Fasern (64) auf einer Oberfläche (61) der Substratanordnung (60) ;
Aufbringen einer Wärmeleitpaste (40) auf die Oberfläche (61) der Substratanordnung (60), wodurch die Vielzahl der Whisker oder Fasern (64) umschlossen wird, die auf der Oberfläche (61) angeordnet sind, wobei eine Vielzahl von wärmeleitenden Partikeln (62) gleichmäßig innerhalb der Wärmeleitpaste (40) verteilt ist; wobei
jede von der Vielzahl der Whisker oder Fasern (64) ein erstes Ende und ein zweites Ende umfasst; wobei das erste Ende von jeder von der Vielzahl der Whisker oder Fasern (64) untrennbar mit der ersten Oberfläche (61) der Substratanordnung (60) verbunden ist; und
mindestens einige von der Vielzahl der Whisker oder Fasern (64) eine Länge haben, die signifikant geringer als eine Dicke (d3) der Wärmeleitpaste (40) ist.

15. Verfahren nach Anspruch 14, wobei mindestens eines der folgenden zutrifft:
das Bilden der Whisker oder Fasern (64) umfasst einen galvanischen Wachstumsprozess; und
die Wärmeleitpaste (40) ist dazu ausgebildet, ihre Phase in Abhängigkeit von der Temperatur zu ändern, und der Schritt des Aufbringens der Wärmeleitpaste (40) umfasst das Erwärmen und Verflüssigen der Wärmeleitpaste (40).

## Revendications

1. Agencement de module à semiconducteur de puissance comprenant :
un puits (30) de chaleur ;
un agencement (60) de substrat disposé sur le puits (30) de chaleur dans une direction verticale ;
une pâte (40) conductrice de la chaleur disposée entre une surface (61) de l'agencement (60) de substrat et une surface (31) du puits (30) de chaleur dans la direction verticale,
dans lequel une pluralité de particules conductrices thermiquement est répartie uniformément au sein de la pâte (40) conductrice de la chaleur ; et
une pluralité de barbes ou de fibres (64), dans lequel chacune de la pluralité de barbes ou de fibres (64) a un premier bout et un second bout ;
**caractérisé en ce que**
le premier bout de chacune de la pluralité de barbes ou de fibres (64) est relié inséparablement, soit à la surface (61) de l'agencement (60) de substrat, soit à la surface (31) du puits (30) de chaleur, mais non aux deux ; et
au moins certaines de la pluralité de barbes ou de fibres (64) ont une longueur, qui est significativement plus petite qu'une distance (d3) entre l'agencement (60) de substrat et le puits (30) de chaleur.

2. Agencement de module à semiconducteur de puissance suivant la revendication 1, dans lequel chacune de la pluralité de barbes ou de fibres (64) s'étend essentiellement dans la direction verticale en passant à travers la pâte (40) conductrice de la chaleur.

3. Agencement de module à semiconducteur de puissance suivant la revendication 1 ou 2, dans lequel
chacune de la pluralité de barbes ou de fibres (64) a une longueur comprise entre 5 µm et 50 µm ou entre 5 µm et 20 µm.

4. Agencement de module à semiconducteur de puissance suivant l'une quelconque des revendications 1 à 3, dans lequel une distance (d3) entre l'agencement (60) de substrat et le puits (30) de chaleur est comprise entre 20 µm et 50 pm.

5. Agencement de module à semiconducteur de puissance suivant l'une quelconque des revendications 1 à 4, dans lequel les barbes ou les fibres (64) comprennent l'un d'un matériau métallique, d'un matériau céramique et du graphène.

6. Agencement de module à semiconducteur de puissance suivant la revendication 5, dans lequel les barbes ou les fibres (64) comprennent au moins l'un d'un oxyde, d'un nitrure, Cu, Al, Cr, Mo, Wo et C.

7. Agencement de module à semiconducteur de puissance suivant l'une quelconque des revendications précédentes, dans lequel l'agencement (60) à semiconducteur comprend un substrat (10) de semiconducteur et dans lequel la première surface (61) est une surface du substrat (10) de semiconducteur.

8. Agencement de module à semiconducteur de puissance suivant l'une quelconque des revendications 1 à 6, dans lequel l'agencement (60) de substrat comprend un substrat (10) de semiconducteur monté sur une plaque (50) de base et dans lequel la première surface (61) est une surface de la plaque (50) de base.

9. Agencement de module à semiconducteur de puissance suivant l'une quelconque des revendications précédentes, dans lequel au moins une première partie de la pluralité de barbes ou de fibres (64) s'étend sur toute la distance (d3) entre l'agencement (60) de substrat et le puits (30) de chaleur, de manière à ce qu'au moins les barbes ou les fibres (64) de la première partie entrent en contact thermiquement à la fois avec l'agencement (60) de substrat et le puits (30) de chaleur.

10. Agencement de module à semiconducteur de puissance suivant l'une quelconque des revendications précédentes, dans lequel une conductibilité thermique de la pluralité de barbes ou de fibres (64) est plus grande qu'une conductibilité thermique de la pâte (40) conductrice de la chaleur.

11. Procédé de fabrication d'un agencement de module à semiconducteur de puissance, procédé dans lequel :
on forme une pluralité de barbes ou de fibres (64) sur au moins l'une d'une surface (31) d'un puits (30) de chaleur et d'une surface (61) d'un agencement (60) de substrat ;
on applique une pâte (40) conductrice de la chaleur à l'une de la surface (61) de l'agencement (60) de substrat et de la surface (31) du puits (30) de chaleur, en enrobant ainsi la pluralité de barbes ou de fibres (64) disposée sur la surface (31, 61) respective, dans lequel une pluralité de particules (62) conductrices thermiquement sont réparties uniformément au sein de la pâte (40) conductrice de la chaleur ;
on monte l'agencement (60) de substrat sur le puits (30) de chaleur, alors que la pâte (40) conductrice de la chaleur et la pluralité de barbes ou de fibres (64) sont disposées entre la surface (61) de l'agencement (60) de substrat et la surface (31) du puits (30) de chaleur ;
dans lequel
chacune de la pluralité de barbes ou de fibres (64) comprend un premier bout et un second bout ;
le premier bout de chacune de la pluralité de barbes ou de fibres (64) est relié inséparablement, soit à la surface (61) de l'agencement (60) de substrat, soit à la surface (31) du puits (30) de chaleur, mais non aux deux ; et
au moins certaines de la pluralité de barbes ou de fibres (64) ont une longueur, qui est significativement plus petite qu'une distance (d3) entre l'agencement (60) de substrat et le puits (30) de chaleur.

12. Procédé suivant la revendication 11, dans lequel au moins l'un de
former les barbes ou les fibres (64) comprend une opération de croissance galvanique ; et
la pâte (40) conductrice de la chaleur est configurée pour changer de phase en fonction de la température, et le stade d'application de la pâte (40) conductrice de la chaleur comprend chauffer et liquéfier la pâte (40) conductrice de la chaleur.

13. Agencement (60) de substrat comprenant
une surface (61) ;
une pluralité de barbes ou de fibres (64) formées sur la surface (61) ; et
une pâte (40) conductrice de la chaleur disposée sur la première surface (61) de l'agencement (60) de substrat et enrobant la pluralité de barbes ou de fibres (64), dans lequel une pluralité de particules (62) conductrices thermiquement sont
réparties uniformément au sein de la pâte (40) conductrice de la chaleur ;
chacune de la pluralité de barbes ou de fibres (64) comprend un premier bout et un second bout ;
le premier bout de chacune de la pluralité de barbes ou de fibres (64) est relié inséparablement à la première surface (61) de l'agencement (60) de substrat ; **caractérisé en ce que**
au moins certaines de la pluralité de barbes ou de fibres (64) ont une longueur, qui est significativement plus petite qu'une épaisseur (d3) de la pâte (40) conductrice de la chaleur.

14. Procédé de fabrication d'un agencement (60) de substrat, procédé dans lequel :
on forme une pluralité de barbes ou de fibres (64) sur une surface (61) de l'agencement (60) de substrat ;
on applique une pâte (40) conductrice de la chaleur à la surface (61) de l'agencement (60) de substrat, en enrobant ainsi la pluralité de barbes ou de fibres (64) disposée sur la surface (61), dans lequel une pluralité de particules (62) conductrices thermiquement sont réparties uniformément au sein de la pâte (40) conductrice de la chaleur ;
dans lequel chacune de la pluralité de barbes ou de fibres (64) a un premier bout et un second bout ;
le premier bout de chacune de la pluralité de barbes ou de fibres (64) est relié inséparablement à la première surface (61) de l'agencement (60) de substrat et
au moins certaines de la pluralité de barbes ou de fibres (64) a une longueur, qui est significativement plus petite qu'une épaisseur (d3) de la pâte (40) conductrice de la chaleur.

15. Procédé suivant la revendication 14, dans lequel au moins l'un de
former les barbes ou les fibres (64) comprend une opération de croissance galvanique ; et
la pâte (40) conductrice de la chaleur est configurée pour changer de phase en fonction de la température et le stade d'application de la pâte (40) conductrice de la chaleur comprend chauffer et liquéfier la pâte (40) conductrice de la chaleur.
